(19)

**Europäisches Patentamt**
**European Patent Office**
**Office européen des brevets**

(11)　**EP 4 145 153 B1**

(12)　　　　　　　　　　**EUROPEAN PATENT SPECIFICATION**

(45) Date of publication and mention
　　 of the grant of the patent:
　　 **30.07.2025　Bulletin 2025/31**

(21) Application number: **21850753.1**

(22) Date of filing: **23.04.2021**

(51) International Patent Classification (IPC):
　　 **G01R 31/327** *(2006.01)*　　　**G01R 15/04** *(2006.01)*
　　 **G01R 31/00** *(2006.01)*

(52) Cooperative Patent Classification (CPC):
　　 **G01R 31/3277**; G01R 31/006; Y02T 10/70;
　　 Y02T 10/7072

(86) International application number:
　　 **PCT/CN2021/089410**

(87) International publication number:
　　 **WO 2022/021964 (03.02.2022 Gazette 2022/05)**

(54) **SWITCH STATE TESTING CIRCUIT, METHOD AND APPARATUS**

　　 SCHALTZUSTANDPRÜFSCHALTUNG, VERFAHREN UND VORRICHTUNG

　　 CIRCUIT, PROCÉDÉ ET APPAREIL DE TEST D'ÉTAT DE COMMUTATEUR

(84) Designated Contracting States:
　　 **AL AT BE BG CH CY CZ DE DK EE ES FI FR GB**
　　 **GR HR HU IE IS IT LI LT LU LV MC MK MT NL NO**
　　 **PL PT RO RS SE SI SK SM TR**

(30) Priority:　**31.07.2020　CN 202010761927**

(43) Date of publication of application:
　　 **08.03.2023　Bulletin 2023/10**

(73) Proprietor: **Huawei Digital Power Technologies**
　　 **Co., Ltd.**
　　 **Shenzhen, Guangdong 518043 (CN)**

(72) Inventors:
　　 • **LIU, Ren**
　　　 **Shenzhen, Guangdong 518129 (CN)**
　　 • **LIANG, Tao**
　　　 **Shenzhen, Guangdong 518129 (CN)**
　　 • **LI, Ping**
　　　 **Shenzhen, Guangdong 518129 (CN)**

　　 • **HU, Yanjun**
　　　 **Shenzhen, Guangdong 518129 (CN)**
　　 • **LI, Dong**
　　　 **Shenzhen, Guangdong 518129 (CN)**

(74) Representative: **Maiwald GmbH**
　　 **Engineering**
　　 **Elisenhof**
　　 **Elisenstrasse 3**
　　 **80335 München (DE)**

(56) References cited:
　　 WO-A2-2018/234259　　CN-A- 102 830 351
　　 CN-A- 102 830 351　　 CN-A- 106 154 145
　　 CN-A- 106 911 160　　 CN-A- 108 469 584
　　 CN-A- 109 239 588　　 CN-A- 112 098 820
　　 CN-U- 211 061 653　　 KR-A- 20140 136 844
　　 KR-A- 20190 069 889　　US-A1- 2019 064 280
　　 US-A1- 2020 049 768

**Description**

**TECHNICAL FIELD**

This application relates to the field of circuit technologies, and in particular, to a switch status detection circuit, method, and apparatus.

**BACKGROUND**

With improvement of people's awareness of environmental protection, electric automobiles become increasingly popular with people. In an electric automobile, the automobile is powered for operating by electric power of a power battery on a load side of the automobile. When charging the power battery, a charging pile charges the power battery by using an on board charger in the electric automobile.

To improve reliability of an electric automobile system and further improve safety performance of the entire vehicle, statuses of two switches of the on board charger usually need to be detected. In a conventional technology, during detection on the statuses of the two switches of the on board charger, a positive-electrode switch detection circuit, a negative-electrode switch detection circuit, and a push-pull circuit are disposed to separately detect a status of a positive-electrode switch and a status of a negative-electrode switch, to complete the detection on the statuses of the two switches of the on board charger.

However, in this detection method, related devices such as the dedicated push-pull circuit need to be added, causing relatively high complexity of the detection circuits. In addition, when capacitors are disposed on both sides of the two switches of the on board charger, alternating-current impedance is reduced when a switch is in an open state, causing false detection on a status of the switch. Therefore, accuracy of a detection result is not high.

US 2019/0064280 A1 describes a battery detection circuit. US 2020/0049768 A1 describes a relay welding detection device including a voltage generator, first and second resistor strings, and a relay welding detector. CN 102830351 A describes a device for condition monitoring and fault diagnosis of a high-voltage switch.

**SUMMARY**

The invention is defined by the independent claims. Further embodiments are defined by the dependent claims. Embodiments of this application provide a switch status detection circuit, method, and apparatus, to not only reduce complexity of a detection circuit, but also improve accuracy of a detection result during detection on a status of a switch.

According to a first aspect, an embodiment of this application provides a switch status detection circuit. The switch status detection circuit may include a first switch, a second switch, a first voltage divider circuit, a second voltage divider circuit, a third voltage divider circuit, and a control chip.

A first end of the first switch is connected to a power source through the first voltage divider circuit, and the first end of the first switch is connected to a power supply module. A second end of the first switch is separately connected to a charging device and a first end of the second voltage divider circuit. A second end of the second voltage divider circuit is grounded. A first end of the second switch is connected to the power source through a first end of the third voltage divider circuit, and the first end of the second switch is connected to the charging device. A second end of the third voltage divider circuit is grounded and is connected to the power supply module. Both a first sampling point of the second voltage divider circuit and a second sampling point of the third voltage divider circuit are connected to the control chip.

The control chip is configured to detect a voltage at the first sampling point, and determine a status of the first switch based on the voltage at the first sampling point. The status includes a closed state, an open state, or a contact failure.

The control chip is further configured to detect a voltage at the second sampling point, and determine a status of the second switch based on the voltage at the second sampling point.

It can be learned that, in this embodiment of this application, the first voltage divider circuit, the second voltage divider circuit, and the third voltage divider circuit are disposed to detect the statuses of the switches. The first voltage divider circuit and the second voltage divider circuit jointly serve as a detection circuit for the first switch. The third voltage divider circuit serves as a detection circuit for the second switch. The first sampling point used for detecting the status of the first switch and the second sampling point used for detecting the status of the second switch are both led out from respective detection circuits and connected to the control chip. The voltages at the sampling points respectively corresponding to the first switch and the second switch are different when the statuses of the first switch and the second switch are different. Therefore, the control chip may determine, through detection, the status of the first switch based on the voltage at the first sampling point, and determine the status of the second switch based on the voltage at the second sampling point, that is, separately determine the status of the first switch and the status of the second switch by detecting voltage division of direct-current impedance. The switch status detection circuit has a simple structure and a relatively low failure rate, thereby improving accuracy of a detection result while reducing complexity of the detection circuit.

In a possible implementation, the switch status detection circuit may further include a clamping circuit, and both the first sampling point of the second voltage divider circuit and the second sampling point of the third voltage divider circuit are connected to the control chip through the clamping circuit.

The clamping circuit is configured to: when the voltage at the first sampling point is higher than a clamping voltage of the clamping circuit, perform clamping processing on the voltage at the first sampling point, so that a processed voltage at the first sampling point is equal to the clamping voltage; and/or

the clamping circuit is configured to: when the voltage at the second sampling point is higher than the clamping voltage of the clamping circuit, perform clamping processing on the voltage at the second sampling point, so that a processed voltage at the second sampling point is equal to the clamping voltage.

It can be learned that, in this embodiment of this application, the clamping circuit is disposed. Therefore, when the voltage at the first sampling point and/or the voltage at the second sampling point are/is relatively high, the clamping circuit may perform clamping processing on the voltage at the first sampling point and/or the voltage at the second sampling point, so that the processed voltage is equal to the clamping voltage, to reduce the voltage at the first sampling point and/or the voltage at the second sampling point, thereby avoiding impact on the control chip or another component when the voltage is relatively high, and protecting the control chip or the another component.

In a possible implementation, the first end of the first switch is connected to the power supply module through a third switch.

The control chip is specifically configured to: if the voltage at the first sampling point is 0 V, determine that the status of the first switch is an open state; if the voltage at the first sampling point is a first preset voltage, determine that the status of the first switch is a closed state; if the voltage at the first sampling point is the clamping voltage, a status of the third switch is a closed state, and failure information used to indicate that the power supply module is not properly charged is received, determine that the status of the first switch is an open state; or if the voltage at the first sampling point is the clamping voltage, a status of the third switch is a closed state, and no failure information used to indicate that the power supply module is not properly charged is received, determine that the status of the first switch is a closed state, thereby monitoring the status of the first switch in real time and effectively ensuring system reliability.

In a possible implementation, the control chip is specifically configured to: if the voltage at the second sampling point is 0 V, determine that the status of the second switch is a closed state; or if the voltage at the second sampling point is a second preset voltage, determine that the status of the second switch is an open state, thereby monitoring the status of the second switch in real time and effectively ensuring system reliability.

In a possible implementation, the first voltage divider circuit includes a first resistor. To be specific, a function of the first voltage divider circuit may be implemented by the first resistor. Alternatively, the first voltage divider circuit may be another component, provided that the function of the first voltage divider circuit can be implemented. Herein, this embodiment of this application is described merely by using an example in which the first voltage divider circuit includes the first resistor. However, this does not mean that this embodiment of this application is limited thereto.

In a possible implementation, the second voltage divider circuit includes a second resistor and a third resistor. To be specific, a function of the second voltage divider circuit may be implemented by the second resistor and the third resistor. Alternatively, the second voltage divider circuit may be another component, provided that the function of the second voltage divider circuit can be implemented. Herein, this embodiment of this application is described merely by using an example in which the second voltage divider circuit includes the second resistor and the third resistor. However, this does not mean that this embodiment of this application is limited thereto.

A first end of the second resistor is separately connected to the charging device and the second end of the first switch. A second end of the second resistor is connected to a first end of the third resistor. A second end of the third resistor is grounded. The first sampling point is located on a connection line between the second end of the second resistor and the first end of the third resistor.

In a possible implementation, the third voltage divider circuit includes a fourth resistor and a fifth resistor. To be specific, a function of the third voltage divider circuit may be implemented by the fourth resistor and the fifth resistor. Alternatively, the third voltage divider circuit may be another component, provided that the function of the third voltage divider circuit can be implemented. Herein, this embodiment of this application is described merely by using an example in which the third voltage divider circuit includes the fourth resistor and the fifth resistor. However, this does not mean that this embodiment of this application is limited thereto.

A first end of the fourth resistor is connected to the power source. The fifth resistor is connected in parallel to the second switch. A first end obtained by connecting the fifth resistor and the second switch in parallel is separately connected to the charging device and a second end of the fourth resistor. A second end obtained by connecting the fifth resistor and the second switch in parallel is grounded and is connected to the power supply module. The second sampling point is located on a connection line between the second end of the fourth resistor and the first end obtained by connecting the fifth resistor and the second switch in parallel.

According to a second aspect, an embodiment of this application further provides a switch status detection method, used for the switch status detection circuit in any one of the possible implementations of the first aspect. The switch status detection method may include:

separately detecting a voltage at a first sampling point and a voltage at a second sampling point; and determining a status of a first switch based on the voltage at the first sampling point, and determining a status of a second switch based on the voltage at the second sampling point, where the status includes a closed state, an open state, or a contact failure.

In a possible implementation, the switch status detection method may further include:

when the voltage at the first sampling point is higher than a clamping voltage of a clamping circuit, performing clamping processing on the voltage at the first sampling point, so that a processed voltage at the first sampling point is equal to the clamping voltage; and/or
when the voltage at the second sampling point is higher than the clamping voltage of the clamping circuit, performing clamping processing on the voltage at the second sampling point, so that a processed voltage at the second sampling point is equal to the clamping voltage.

In a possible implementation, the determining a status of a first switch based on the voltage at the first sampling point may include:

if the voltage at the first sampling point is 0 V, determining, by a control chip, that the status of the first switch is an open state;
if the voltage at the first sampling point is a first preset voltage, determining, by a control chip, that the status of the first switch is a closed state;
if the voltage at the first sampling point is the clamping voltage, a status of a third switch is a closed state, and failure information used to indicate that a power supply module is not properly charged is received, determining that the status of the first switch is an open state; or
if the voltage at the first sampling point is the clamping voltage, a status of a third switch is a closed state, and no failure information used to indicate that a power supply module is not properly charged is received, determining that the status of the first switch is a closed state.

In a possible implementation, the determining a status of a second switch based on the voltage at the second sampling point may include:

if the voltage at the second sampling point is 0 V, determining that the status of the second switch is a closed state; or
if the voltage at the second sampling point is a second preset voltage, determining that the status of the second switch is an open state.

According to a third aspect, an embodiment of this application further provides a switch status detection apparatus. The switch status detection apparatus may include a power supply module and the switch status detection circuit in any one of the possible implementations of the first aspect. A first end of the switch status detection circuit is connected to a charging device. A second end of the switch status detection circuit is connected to the power supply module.
the charging device charges the power supply module by using the switch status detection circuit.

According to a fourth aspect, an embodiment of this application further provides an electric device. The electric device may include the switch status detection apparatus in any one of the possible implementations of the first aspect.

Embodiments of this application provide a switch status detection circuit, method, and apparatus. The circuit includes a first switch, a second switch, a first voltage divider circuit and a second voltage divider circuit that jointly serve as a detection circuit for the first switch, and a third voltage divider circuit that serves as a detection circuit for the second switch. A first sampling point used for detecting a status of the first switch and a second sampling point used for detecting a status of the second switch are both led out from respective detection circuits and connected to a control chip. Voltages at the sampling points respectively corresponding to the first switch and the second switch are different when the statuses of the first switch and the second switch are different. Therefore, when detecting the statuses of the switches, the control chip may determine the status of the first switch based on a voltage at the first sampling point, and determine the status of the second switch based on a voltage at the second sampling point, that is, separately determine the status of the first switch and the status of the second switch by detecting voltage division of direct-current impedance. The switch status detection circuit has a simple structure and a relatively low failure rate, thereby improving accuracy of a detection result while reducing complexity of the detection circuit.

## BRIEF DESCRIPTION OF DRAWINGS

FIG. 1 is a schematic diagram of an application scenario according to an embodiment of this application;

FIG. 2 is a schematic diagram of a switch status detection circuit in a conventional technology;

FIG. 3 is a schematic diagram of a structure of a switch status detection circuit according to an embodiment of this application;

FIG. 4 is a schematic connection diagram of a switch status detection circuit according to an embodiment of this application;

FIG. 5 is a schematic diagram of a structure of another switch status detection circuit according to an embodiment of this application;

FIG. 6 is a schematic diagram of a structure of still another switch status detection circuit according to an embodiment of this application;

FIG. 7 is a schematic diagram of a structure of a switch status detection circuit according to an embodiment of this application;

FIG. 8 is a schematic diagram of a structure of another switch status detection circuit according to an embodiment of this application;

FIG. 9 is a schematic diagram of a standard sequence diagram and a detection window of a switch according to an embodiment of this application; and

FIG. 10 is a schematic flowchart of a switch status detection method according to an embodiment of this application.

## DESCRIPTION OF EMBODIMENTS

A switch status detection circuit provided in embodiments of this application may be used in a scenario of charging an electric vehicle, or may be used in another similar scenario in which a status of a switch needs to be detected. When technical solutions are subsequently described, that the switch status detection circuit is used in the scenario of charging an electric vehicle is used as an example for description in embodiments of this application. However, this does not mean that embodiments of this application are limited thereto.

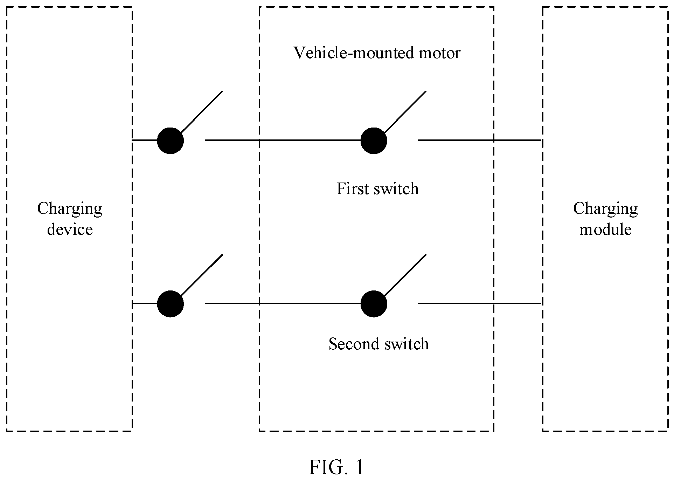

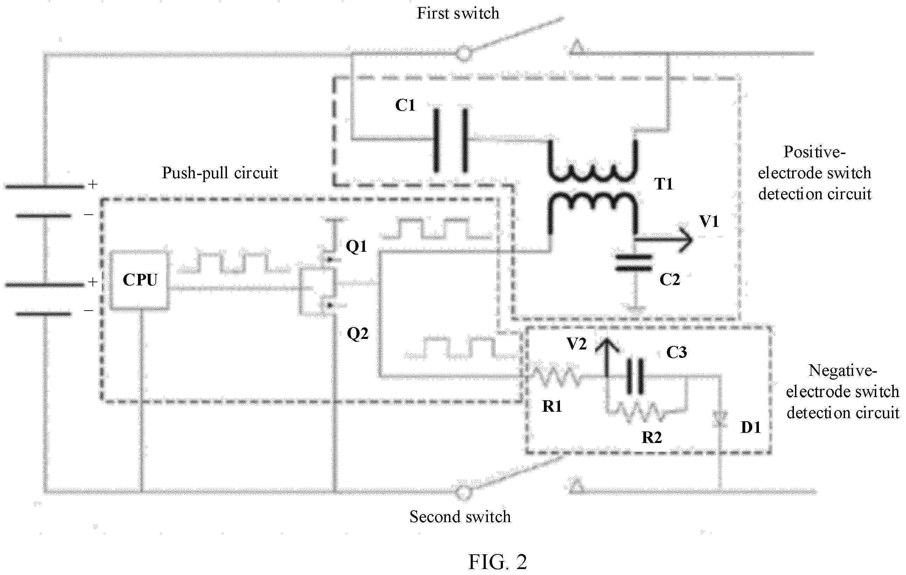

FIG. 1 is a schematic diagram of an application scenario according to an embodiment of this application. When charging a charging module such as a power battery in an electric automobile, a charging device such as a charging pile charges the power battery by using a vehicle-mounted motor in the electric automobile. To eliminate a risk of an electric shock, statuses of two switches in the vehicle-mounted motor usually need to be detected. In a conventional technology, during detection on the statuses of the two switches, refer to FIG. 2. FIG. 2 is a schematic diagram of a switch status detection circuit in a conventional technology. In the detection circuit shown in FIG. 2, a positive-electrode switch detection circuit, a negative-electrode switch detection circuit, and a push-pull circuit are disposed to separately detect a status of a positive-electrode switch and a status of a negative-electrode switch. Specifically, during detection on the status of the positive-electrode switch, a voltage amplitude V1 of a charging/discharging circuit may be first collected. The positive-electrode switch is opened, and then a voltage amplitude V1-1 of the charging/discharging circuit is collected. The positive-electrode switch is closed, and then a voltage amplitude V1-2 of the charging/discharging circuit is collected. If V1 is equal to V1-1 or greater than a first preset threshold, it may be determined that the positive-electrode switch is in an open state, a non-adhesion state, or an open-circuit state. If V1 is equal to V1-2 or less than the first preset threshold, it may be determined that the positive-electrode switch is in a closed state, an adhesion state, or a non-open-circuit state. The first preset threshold is greater than V1-2 and less than V1-1.

During detection on the status of the negative-electrode switch, a voltage amplitude V2 of a capacitor unit in an RC circuit may be first collected. The negative-electrode switch is opened, and then a voltage amplitude V2-1 of the capacitor unit in the RC circuit is collected. The negative-electrode switch is closed, and then a voltage amplitude V2-2 of the capacitor unit in the RC circuit is collected. If V2 is equal to V2-1 or greater than a second preset threshold, it may be determined that the negative-electrode switch is in an open state, a non-adhesion state, or an open-circuit state. If V2 is equal to V2-2 or less than the second preset threshold, it may be determined that the negative-electrode switch is in a closed state, an adhesion state, or a non-open-circuit state. The second preset threshold is greater than V2-2 and less than V2-1. In this way, the detection on the statuses of the two switches, that is, the positive-electrode switch and the negative-electrode switch is completed. However, in this detection method, related devices such as the dedicated push-pull circuit need to be added, causing relatively high complexity of the detection circuits. In addition, when capacitors are disposed on both sides of the two switches of the on board charger, alternating-current impedance is reduced when a switch is in an open state, causing false detection on a status of the switch. Therefore, accuracy of a detection result is not high.

Based on the detection circuit shown in FIG. 2, during detection on a status of a switch, to reduce complexity of a detection circuit and improve accuracy of a detection result, on one hand, a quantity of related devices in the detection circuit may be reduced to reduce complexity of the detection circuit. However, if the quantity of related devices is reduced, the status of the switch cannot be detected. On the other hand, the switch may be prevented from being in an open state as far as possible. However, this is difficult to ensure. Therefore, how to improve accuracy of a detection result while reducing complexity of a detection circuit is an issue that urgently needs to be addressed by persons skilled in the art.

Based on this, an embodiment of this application provides a switch status detection circuit. The switch status detection circuit may include a first switch, a second switch, a first voltage divider circuit, a second voltage divider circuit, a third voltage divider circuit, and a control chip. A first end of the first switch is connected to a power source through the first voltage divider circuit, and the first end of the first switch is connected to a power supply module. A second end of the first switch is separately connected to a charging device and a first end of the second voltage divider circuit. A second end of the second voltage divider circuit is grounded. A first end of the second switch is connected to the power source through a first end of the third voltage divider circuit, and the first end of the second switch is connected to the charging device. A second end of the third voltage divider circuit is grounded and is connected to the power supply module. Both a first sampling point of the second voltage divider circuit and a second sampling point of the third voltage divider circuit are connected to the control chip. Therefore, the control chip may detect a voltage at the first sampling point, and determine a status of the first switch based on the voltage at the first sampling point; and detect a voltage at the second sampling point, and determine a status of the second switch based on the voltage at the second sampling point. The status of the switch includes a closed state, an open state, or a contact failure.

It can be learned that, in this embodiment of this application, the first voltage divider circuit, the second voltage divider circuit, and the third voltage divider circuit are disposed to detect the statuses of the switches. The first voltage divider circuit and the second voltage divider circuit jointly serve as a detection circuit for the first switch. The third voltage divider circuit serves as a detection circuit for the second switch. The first sampling point used for detecting the status of the first switch and the second sampling point used for detecting the status of the second switch are both led out from respective detection circuits and connected to the control chip. The voltages at the sampling points respectively corresponding to the first switch and the second switch are different when the statuses of the first switch and the second switch are different. Therefore, the control chip may determine, through detection, the status of the first switch based on the voltage at the first sampling point, and determine the status of the second switch based on the voltage at the second sampling point, that is, separately determine the status of the first switch and the status of the second switch by detecting voltage division of direct-current impedance. The switch status detection circuit has a simple structure and a relatively low failure rate, thereby improving accuracy of a detection result while reducing complexity of the detection circuit.

By using the following several embodiments, the following describes in detail technical solutions of the switch status detection circuit provided in this embodiment of this application. It should be noted that the following several specific embodiments may be combined with each other, and a same or similar concept or process may not be described repeatedly in some embodiments.

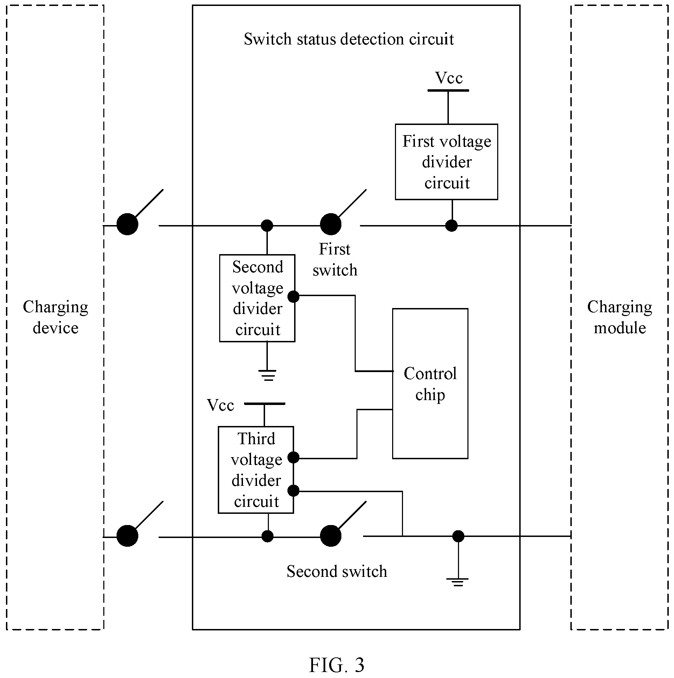

FIG. 3 is a schematic diagram of a structure of a switch status detection circuit according to an embodiment of this application. For example, referring to FIG. 3, the switch status detection circuit may include:

a first switch, a second switch, a first voltage divider circuit, a second voltage divider circuit, a third voltage divider circuit, and a control chip. A first end of the first switch is connected to a power source through the first voltage divider circuit, and the first end of the first switch is connected to a power supply module. A second end of the first switch is separately connected to a charging device and a first end of the second voltage divider circuit. A second end of the second voltage divider circuit is grounded. A first end of the second switch is connected to the power source through a first end of the third voltage divider circuit, and the first end of the second switch is connected to the charging device. A second end of the third voltage divider circuit is grounded and is connected to the power supply module. Both a first sampling point of the second voltage divider circuit and a second sampling point of the third voltage divider circuit are connected to the control chip.

The control chip is configured to detect a voltage at the first sampling point, and determine a status of the first switch based on the voltage at the first sampling point. The status includes a closed state, an open state, or a contact failure.

The control chip is further configured to detect a voltage at the second sampling point, and determine a status of the second switch based on the voltage at the second sampling point.

For example, the charging device in this embodiment of this application may be a direct-current source, and the direct-current source may be a charging power source of any form or specification. The power supply module may be a power battery made of any material, and may be specifically disposed according to an actual requirement. Specific meanings of the charging device and the power supply module are not further limited in this embodiment of this application.

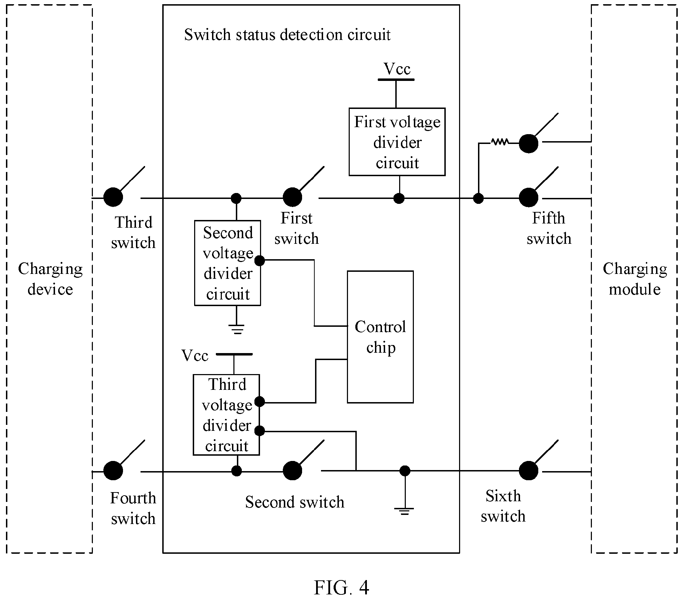

Based on the switch status detection circuit shown in FIG. 3, specifically, when the second end of the first switch is connected to the charging device, the second end of the first switch may be connected to the charging device through a third switch; and when the first end of the second switch is connected to the charging device, the first end of the second switch may be connected to the charging device through a fourth switch. Similarly, when the first end of the first switch is connected to the power supply module, the first end of the first switch may be connected to the power supply module through a fifth switch; and when the second end of the third voltage divider circuit is grounded and is connected to the power supply module, the second end of the third voltage divider circuit may be connected to the power supply module through a sixth switch, as shown in FIG. 4. FIG. 4 is a schematic connection diagram of a switch status detection circuit according to an embodiment of this application. It should be noted that, to reduce capacitance impact on the fifth switch when the charging module is charged, a soft start resistor and a soft start switch are usually disposed. The soft start resistor and the soft start switch are connected in parallel to the fifth switch and are connected to the first switch, to reduce the capacitance impact on the fifth switch and protect the fifth switch.

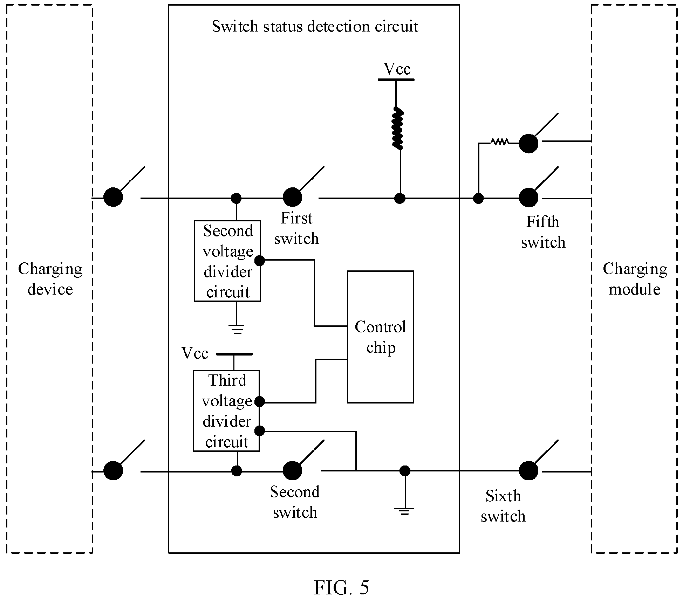

For example, in this embodiment of this application, the first voltage divider circuit may include a first resistor, as shown in FIG. 5. FIG. 5 is a schematic diagram of a structure of another switch status detection circuit according to an embodiment of this application. To be specific, a function of the first voltage divider circuit may be implemented by the first resistor. Alternatively, the first voltage divider circuit may be another component, provided that the function of the first voltage divider circuit can be implemented. Herein, this embodiment of this application is described merely by using an example in which the first voltage divider circuit includes the first resistor. However, this does not mean that this embodiment of this application is limited thereto.

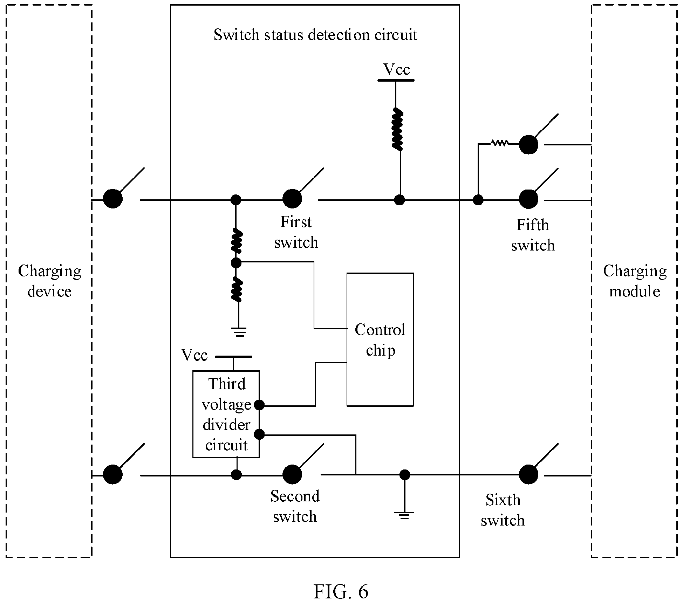

For example, the second voltage divider circuit may include a second resistor and a third resistor, as shown in FIG. 6. FIG. 6 is a schematic diagram of a structure of still another switch status detection circuit according to an embodiment of this application. A first end of the second resistor is separately connected to the charging device and the second end of the first switch. A second end of the second resistor is connected to a first end of the third resistor. A second end of the third resistor is grounded. The first sampling point is located on a connection line between the second end of the second resistor and the first end of the third resistor. To be specific, a function of the second voltage divider circuit may be implemented by the second resistor and the third resistor. Alternatively, the second voltage divider circuit may be another component, provided that the function of the second voltage divider circuit can be implemented. Herein, this embodiment of this application is described merely by using an example in which the second voltage divider circuit includes the second resistor and the third resistor. However, this does not mean that this embodiment of this application is limited thereto.

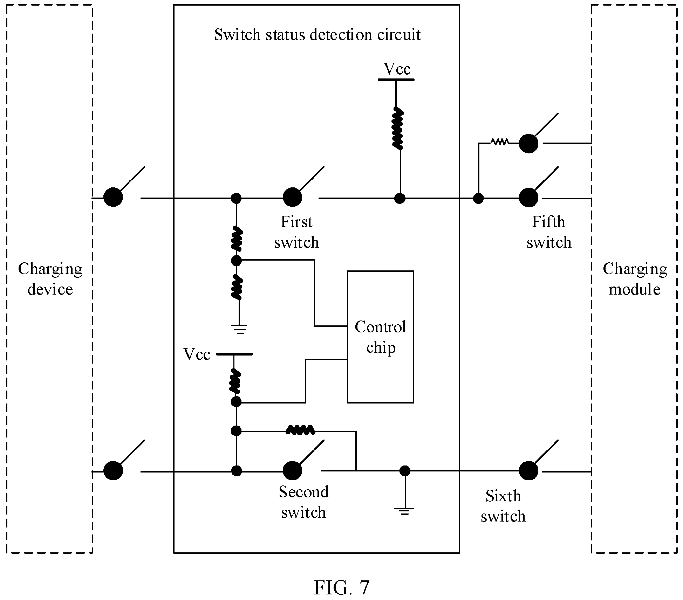

For example, the third voltage divider circuit may include a fourth resistor and a fifth resistor, as shown in FIG. 7. FIG. 7 is a schematic diagram of a structure of a switch status detection circuit according to an embodiment of this application. A first end of the fourth resistor is connected to the power source. The fifth resistor is connected in parallel to the second switch. A first end obtained by connecting the fifth resistor and the second switch in parallel is separately connected to the charging device and a second end of the fourth resistor. A second end obtained by connecting the fifth resistor and the second switch in parallel is grounded and is connected to the power supply module. The second sampling point is located on a connection line between the second end of the fourth resistor and the first end obtained by connecting the fifth resistor and the second switch in parallel. To be specific, a function of the third voltage divider circuit may be implemented by the fourth resistor and the fifth resistor. Alternatively, the third voltage divider circuit may be another component, provided that the function of the third voltage divider circuit can be implemented. Herein, this embodiment of this application is described merely by using an example in which the third voltage divider circuit includes the fourth resistor and the fifth resistor. However, this does not mean that this embodiment of this application is limited thereto.

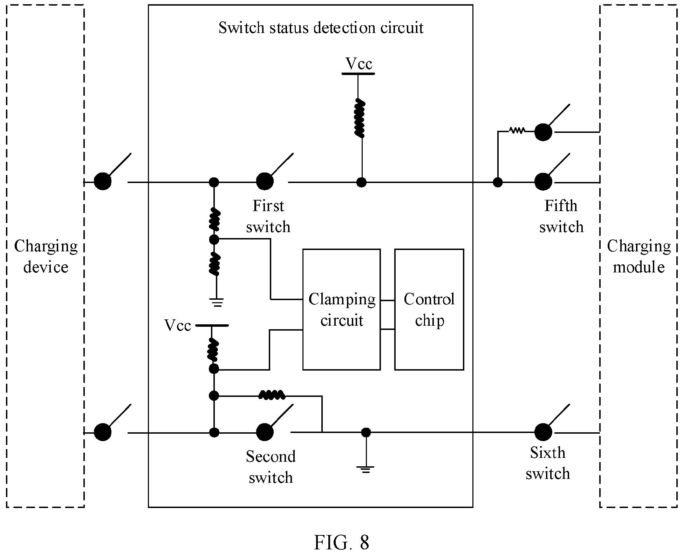

When determining the status of the first switch and the status of the first switch based on the voltage at the first sampling point and the voltage at the second sampling point respectively, the control chip needs to separately detect the voltage at the first sampling point and the voltage at the second sampling point. The voltage at the first sampling point and/or the voltage at the second sampling point may be a relatively high voltage or a relatively low voltage. When the voltage at the first sampling point and/or the voltage at the second sampling point are/is relatively high, for example, higher than a clamping voltage, the relatively high voltage may affect the control chip or another component. Therefore, a clamping circuit may be disposed in the switch status detection circuit. For example, FIG. 8 is a schematic diagram of a structure of another switch status detection circuit according to an embodiment of this application. Both the first sampling point of the second voltage divider circuit and the second sampling point of the third voltage divider circuit are connected to the control chip through the clamping circuit.

The clamping circuit is configured to: when the voltage at the first sampling point is higher than a clamping voltage of the clamping circuit, perform clamping processing on the voltage at the first sampling point, so that a processed voltage at the first sampling point is equal to the clamping voltage; and/or the clamping circuit is configured to: when the voltage at the second sampling point is higher than the clamping voltage of the clamping circuit, perform clamping processing on the voltage at the second sampling point, so that a processed voltage at the second sampling point is equal to the clamping voltage.

It can be learned that, in this embodiment of this application, the clamping circuit is disposed. Therefore, when the voltage at the first sampling point and/or the voltage at the second sampling point are/is relatively high, the clamping circuit may perform clamping processing on the voltage at the first sampling point and/or the voltage at the second sampling point, so that the processed voltage is equal to the clamping voltage, to reduce the voltage at the first sampling point and/or the voltage at the second sampling point, thereby avoiding impact on the control chip or another component when the voltage is relatively high, and protecting the control chip or the another component.

It is easily understood that, in this embodiment of this application, the status of the first switch and the status of the second switch may be determined based on the voltage at the first sampling point and the voltage at the second sampling point respectively, because the voltages at the sampling points respectively corresponding to the first switch and the second switch are different when the statuses of the first switch and the second switch are different. Therefore, voltages at a sampling point corresponding to a switch when the switch is in different statuses may be analyzed first. In this way, the control chip may determine the status of the first switch and the status of the firstswitch based on the voltage at the first sampling point and the voltage at the second sampling point respectively, thereby improving accuracy of a detection result while reducing complexity of the detection circuit.

For example, during analysis on voltages at the first sampling point corresponding to the first switch when the first switch is in different statuses, the voltages at the first sampling point corresponding to the first switch when the first switch is in different statuses may be analyzed with reference to a status of the third switch and a status of the fifth switch. During analysis on voltages at the second sampling point corresponding to the second switch when the second switch is in different statuses, the voltages at the second sampling point corresponding to the second switch when the second switch is in different statuses may be analyzed with reference to a status of the fourth switch and a status of the sixth switch. Analysis may be performed with reference to three different scenarios.

In a scenario, during analysis on the voltages at the first sampling point corresponding to the first switch when the first switch is in different statuses, refer to Table 1 below. It can be learned that, when the third switch of the charging module is open without output and the fifth switch is open, if the first switch is closed, the voltage at the first sampling point is a first

$$V_1 = V_{cc} \cdot \frac{R_3}{R_1 + R_2 + R_3}$$

preset voltage, and the first preset voltage is as follows: ; or if the first switch is open, the first sampling point is grounded through the third resistor, and in this case, the voltage at the first sampling point is as follows: V1 = 0. When the third switch of the charging module is open without output and the fifth switch is closed, if the first switch is closed, a high voltage of the charging module is injected into the second resistor and the third resistor through the fifth switch, the voltage V1 at the first sampling point is a high voltage, and the high voltage is clamped by the clamping circuit, so that the voltage at the first sampling point is as follows: V1 = the clamping voltage; or if the first switch is open, the voltage V1 at the first sampling point is also a high voltage, and the high voltage is also clamped by the clamping circuit, so that the voltage at the first sampling point is as follows: V1 = the clamping voltage, as shown in Table 1 below.

**Table 1**

| Status of the third switch | Whether there is output | Status of the fifth switch | Status of the first switch | Voltage at the first sampling point |
|---|---|---|---|---|
| Open | No output | Open | Closed | $V_1 = V_{cc} \cdot \dfrac{R_3}{R_1 + R_2 + R_3}$ |
| | | | Open | 0 |
| | | Closed | Closed | Clamping voltage |
| | | | Open | Clamping voltage |

After the voltages at the first sampling point corresponding to the first switch when the first switch is in different statuses are obtained through analysis with reference to Table 1, the status of the first switch may be determined based on the voltage at the first sampling point. In this scenario, if it is detected that the voltage at the first sampling point is the first preset voltage, it may be determined that the status of the first switch is a closed state. If it is detected that the voltage at the first sampling point is 0 V, it may be determined that the status of the first switch is an open state. If it is detected that the voltage at the first sampling point is the clamping voltage, when the third switch of the charging module is open without output and the fifth switch is closed, the voltage at the first sampling point is the clamping voltage regardless of whether the first switch is open or closed. Therefore, in this case, the status of the first switch cannot be determined based on the voltage at the first sampling point. However, for the first two cases in Table 1, the status of the first switch may still be determined based on the voltage at the first sampling point.

In this scenario, during analysis on the voltages at the second sampling point corresponding to the second switch when the second switch is in different statuses, refer to Table 2 below. It can be learned that, when the fourth switch of the charging module is open without output and the sixth switch is open, if the second switch is closed, the voltage at the second sampling point is as follows: V2 = 0; or when the fourth switch of the charging module is open without output and the sixth switch is open, if the second switch is open, the voltage at the second sampling point is a second preset voltage, and

8

$$V_2 = V_{cc} \cdot \frac{R_5}{R_5 + R_6}$$

the second preset voltage is as follows: . When the fourth switch of the charging module is open without output and the sixth switch is closed, if the second switch is closed, the voltage at the second sampling point is as follows: V2 = 0; or when the fourth switch of the charging module is open without output and the sixth switch is closed, if the second switch is open, the voltage at the second sampling point is a second preset voltage, and the second preset voltage

$$V_2 = V_{cc} \cdot \frac{R_5}{R_5 + R_6}$$

is as follows: , as shown in Table 2 below.

**Table 2**

| Status of the fourth switch | Whether there is output | Status of the sixth switch | Status of the second switch | Voltage at the second sampling point |
|---|---|---|---|---|
| Open | No output | Open | Closed | 0 |
| | | | Open | $V_2 = V_{cc} \cdot \dfrac{R_5}{R_5 + R_6}$ |
| | | Closed | Closed | 0 |
| | | | Open | $V_2 = V_{cc} \cdot \dfrac{R_5}{R_5 + R_6}$ |

After the voltages at the second sampling point corresponding to the second switch when the second switch is in different statuses are obtained through analysis with reference to Table 2, the status of the second switch may be determined based on the voltage at the second sampling point. In this scenario, if it is detected that the voltage at the second sampling point is 0, it may be determined that the status of the second switch is a closed state. If it is detected that the voltage at the second sampling point is a second preset voltage, it may be determined that the status of the second switch is an open state. The detection on the status of the second switch is irrelevant to the status of the fourth switch and the status of the sixth switch. In this case, the status of the second switch may be determined based on the voltage at the second sampling point.

In another scenario, during analysis on the voltages at the first sampling point corresponding to the first switch when the first switch is in different statuses, refer to Table 3 below. It can be learned that, when the third switch of the charging module is closed without output and the fifth switch is open, if the first switch is closed, the voltage at the first

$$V_1 = V_{cc} \cdot \frac{R_3}{R_1 + R_2 + R_3}$$

sampling point is as follows: ; or if the first switch is open, the first sampling point is grounded through the third resistor, and in this case, the voltage at the first sampling point is as follows: V1 = 0. When the third switch of the charging module is closed without output and the fifth switch is closed, if the first switch is closed, a high voltage of the charging module is injected into the second resistor and the third resistor through the fifth switch, the voltage V1 at the first sampling point is a high voltage, and the high voltage is clamped by the clamping circuit, so that the voltage at the first sampling point is as follows: V1 = the clamping voltage; or if the first switch is open, the voltage V1 at the first sampling point is also a high voltage, and the high voltage is also clamped by the clamping circuit, so that the voltage at the first sampling point is as follows: V1 = the clamping voltage, as shown in Table 3 below.

**Table 3**

| Status of the third switch | Whether there is output | Status of the fifth switch | Status of the first switch | Voltage at the first sampling point |
|---|---|---|---|---|
| Closed | No output | Open | Closed | $V_1 = V_{cc} \cdot \dfrac{R_3}{R_1 + R_2 + R_3}$ |
| | | | Open | 0 |
| | | Closed | Closed | Clamping voltage |
| | | | Open | Clamping voltage |

After the voltages at the first sampling point corresponding to the first switch when the first switch is in different statuses are obtained through analysis with reference to Table 3, the status of the first switch may be determined based on the voltage at the first sampling point. In this scenario, if it is detected that the voltage at the first sampling point is the first preset voltage, it may be determined that the status of the first switch is a closed state. If it is detected that the voltage at the first sampling point is 0 V, it may be determined that the status of the first switch is an open state. If it is detected that the voltage at the first sampling point is the clamping voltage, when the third switch of the charging module is closed without output and the fifth switch is closed, the voltage at the first sampling point is the clamping voltage regardless of whether the first switch is open or closed. Therefore, in this case, the status of the first switch cannot be determined based on the voltage at the first sampling point. However, for the first two cases in Table 3, the status of the first switch may still be determined based on the voltage at the first sampling point.

In this scenario, during analysis on the voltages at the second sampling point corresponding to the second switch when the second switch is in different statuses, refer to Table 4 below. It can be learned that, when the fourth switch of the charging module is closed without output and the sixth switch is open, if the second switch is closed, the voltage at the second sampling point is as follows: V2 = 0; or when the fourth switch of the charging module is closed without output and the sixth switch is open, if the second switch is open, the voltage at the second sampling point is a second preset voltage,

$$V_2 = V_{cc} \cdot \frac{R_5}{R_5 + R_6}$$

and the second preset voltage is as follows: . When the fourth switch of the charging module is closed without output and the sixth switch is closed, if the second switch is closed, the voltage at the second sampling point is as follows: V2 = 0; or when the fourth switch of the charging module is closed without output and the sixth switch is closed, if the second switch is open, the voltage at the second sampling point is a second preset voltage, and the second preset voltage

$$V_2 = V_{cc} \cdot \frac{R_5}{R_5 + R_6}$$

is as follows: , as shown in Table 4 below.

**Table 4**

| Status of the fourth switch | Whether there is output | Status of the sixth switch | Status of the second switch | Voltage at the second sampling point |
|---|---|---|---|---|
| Closed | No output | Open | Closed | 0 |
| | | | Open | $V_2 = V_{cc} \cdot \dfrac{R_5}{R_5 + R_6}$ |
| | | Closed | Closed | 0 |
| | | | Open | $V_2 = V_{cc} \cdot \dfrac{R_5}{R_5 + R_6}$ |

After the voltages at the second sampling point corresponding to the second switch when the second switch is in different statuses are obtained through analysis with reference to Table 4, the status of the second switch may be determined based on the voltage at the second sampling point. In this scenario, if it is detected that the voltage at the second sampling point is 0, it may be determined that the status of the second switch is a closed state. If it is detected that the voltage at the second sampling point is a second preset voltage, it may be determined that the status of the second switch is an open state. The detection on the status of the second switch is irrelevant to the status of the fourth switch and the status of the sixth switch. In this case, the status of the second switch may be determined based on the voltage at the second sampling point.

In still another scenario, during analysis on the voltages at the first sampling point corresponding to the first switch when the first switch is in different statuses, refer to Table 5 below. It can be learned that, when the third switch of the charging module is closed with output and the fifth switch is open, if the first switch is closed, a high voltage of the charging device is introduced into a reference ground Vcc_GND through the second resistor and the third resistor, the voltage V1 at the first sampling point is a high voltage, and the high voltage is clamped by the clamping circuit, so that the voltage at the first sampling point is as follows: V1 = the clamping voltage. If the first switch is open, the high voltage of the charging device is also introduced into the reference ground Vcc_GND through the second resistor and the third resistor, the voltage V1 at the first sampling point is a high voltage, and the high voltage is also clamped by the clamping circuit, so that the voltage at the first sampling point is as follows: V1 = the clamping voltage. In other words, when the third switch of the charging module is closed with output and the fifth switch is open, the high voltage of the charging device is introduced into the reference ground Vcc_GND through the second resistor and the third resistor, and the high voltage at the first sampling point is clamped to the clamping voltage, regardless of whether the first switch is closed, as shown in Table 5 below.

**Table 5**

| Status of the third switch | Whether there is output | Status of the fifth switch | Status of the first switch | Voltage at the first sampling point |
| --- | --- | --- | --- | --- |
| Closed | There is output | Open | Closed | Clamping voltage |
| | | | Open | Clamping voltage |
| | | Closed | Closed | Clamping voltage |
| | | | Open | Clamping voltage |

After the voltages at the first sampling point corresponding to the first switch when the first switch is in different statuses are obtained through analysis with reference to Table 5, the status of the first switch may be determined based on the voltage at the first sampling point. In this scenario, when the third switch is closed with output, the voltage at the first sampling point is the clamping voltage regardless of whether the first switch is closed or open. Therefore, the status of the first switch cannot be determined only based on the voltage at the first sampling point. However, when the third switch of the charging module is closed with output and the fifth switch is closed, if the first switch is closed, it indicates that a power supply status is normal, the voltage V1 at the first sampling point is a high voltage, and the high voltage is clamped by the clamping circuit, so that the voltage at the first sampling point is as follows: V1 = the clamping voltage. If the first switch is open, it indicates that a power supply exception occurs. In this case, the voltage V1 at the first sampling point is also a high voltage, and the high voltage is also clamped by the clamping circuit, so that the voltage at the first sampling point is as follows: V1 = the clamping voltage. However, because the charging module reports a charging failure, the control chip may determine the status of the first switch based on the voltage at the first sampling point and whether charging failure information is received. If the voltage at the first sampling point is as follows: V1 = the clamping voltage, and no charging failure information is received, the status of the first switch is a closed state; or if the voltage at the first sampling point is as follows: V1 = the clamping voltage, and charging failure information is received, it is determined that the status of the first switch is an open state, thereby obtaining the status of the first switch.

In this scenario, during analysis on the voltages at the second sampling point corresponding to the second switch when the second switch is in different statuses, refer to Table 6 below. It can be learned that, when the fourth switch of the charging module is closed with output and the sixth switch is open, if the second switch is closed, the voltage at the second sampling point is as follows: V2 = 0; or when the fourth switch of the charging module is closed with output and the sixth switch is open, if the second switch is open, the voltage at the second sampling point is a second preset voltage, and the

$$V_2 = V_{cc} \cdot \frac{R_5}{R_5 + R_6}$$

second preset voltage is as follows:                      . When the fourth switch of the charging module is closed with output and the sixth switch is closed, if the second switch is closed, the voltage at the second sampling point is as follows:

V2 = 0; or when the fourth switch of the charging module is closed with output and the sixth switch is open, if the second switch is closed, the voltage at the second sampling point is a second preset voltage, and the second preset voltage is as

$$V_2 = V_{cc} \cdot \frac{R_5}{R_5 + R_6}$$

follows: , as shown in Table 6 below.

**Table 6**

| Status of the fourth switch | Whether there is output | Status of the sixth switch | Status of the second switch | Voltage at the second sampling point |
|---|---|---|---|---|
| Closed | There is output | Open | Closed | 0 |
| | | | Open | $V_2 = V_{cc} \cdot \dfrac{R_5}{R_5 + R_6}$ |
| | | Closed | Closed | 0 |
| | | | Open | $V_2 = V_{cc} \cdot \dfrac{R_5}{R_5 + R_6}$ |

After the voltages at the second sampling point corresponding to the second switch when the second switch is in different statuses are obtained through analysis with reference to Table 6, the status of the second switch may be determined based on the voltage at the second sampling point. In this scenario, if it is detected that the voltage at the second sampling point is 0, it may be determined that the status of the second switch is a closed state. If it is detected that the voltage at the second sampling point is a second preset voltage, it may be determined that the status of the second switch is an open state. The detection on the status of the second switch is irrelevant to the status of the fourth switch and the status of the sixth switch. In this case, the status of the second switch may be determined based on the voltage at the second sampling point.

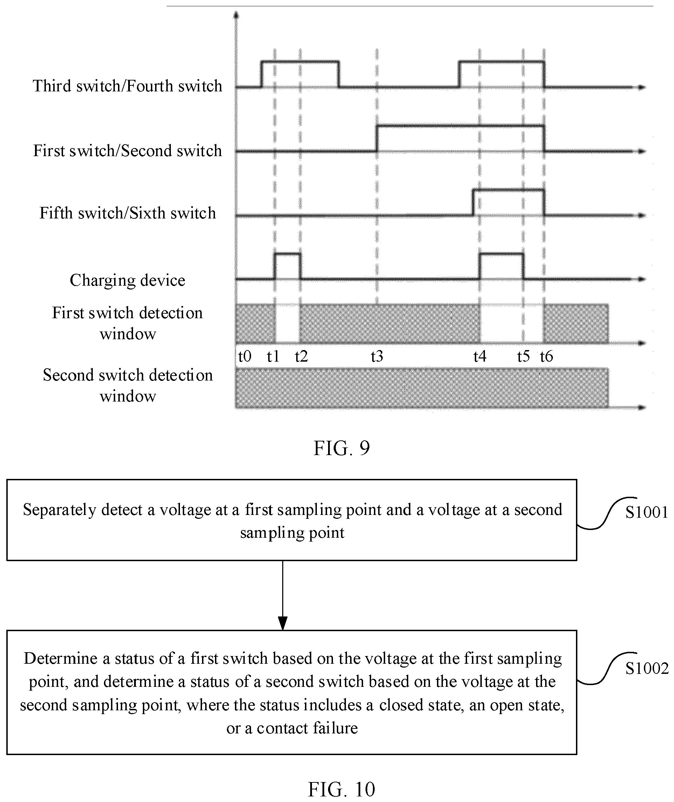

With reference to the related descriptions of Table 1 to Table 6, cases of determining the status of the first switch and the status of the second switch may be described by using a standard sequence diagram and a detection window of the switch. For example, FIG. 9 is a schematic diagram of a standard sequence diagram and a detection window of a switch according to an embodiment of this application. It can be learned that, during detection on the status of the first switch, when the third switch of the charging module is open without output and the fifth switch is open, the status of the first switch may be determined based on the voltage at the first sampling point; when the third switch of the charging module is closed without output and the fifth switch is open, the status of the first switch may be determined based on the voltage at the first sampling point; or when the third switch of the charging module is closed with output and the fifth switch is closed, the status of the first switch may be determined based on both the voltage at the first sampling point and whether charging failure information is received, thereby monitoring the status of the first switch in real time and effectively ensuring system reliability. During detection on the status of the second switch, because the detection on the status of the second switch is irrelevant to the status of the fourth switch and the status of the sixth switch, the status of the second switch may be determined based on the voltage at the second sampling point in any scenario, thereby monitoring the status of the second switch in real time and effectively ensuring system reliability.

It can be understood that, in this embodiment of this application, after the status of the first switch and the status of the second switch are separately determined, whether the first switch or the second switch is adhered may be further determined based on the status of the first switch and the status of the second switch. If it is determined that a switch of the first switch and the second switch is adhered, an alarm mode is triggered, to report a switch failure.

It can be learned that, in the switch status detection circuit provided in this embodiment of this application, the first voltage divider circuit, the second voltage divider circuit, and the third voltage divider circuit are disposed to detect the statuses of the switches. The first voltage divider circuit and the second voltage divider circuit jointly serve as a detection circuit for the first switch. The third voltage divider circuit serves as a detection circuit for the second switch. The first sampling point used for detecting the status of the first switch and the second sampling point used for detecting the status of the second switch are both led out from respective detection circuits and connected to the control chip. The voltages at the sampling points respectively corresponding to the first switch and the second switch are different when the statuses of the first switch and the second switch are different. Therefore, the control chip may determine, through detection, the status of the first switch based on the voltage at the first sampling point, and determine the status of the second switch based on the voltage at the second sampling point, that is, separately determine the status of the first switch and the status of the second switch by detecting voltage division of direct-current impedance. The switch status detection circuit has a simple structure and a relatively low failure rate, thereby improving accuracy of a detection result while reducing complexity of the detection circuit.

Based on the switch status detection circuit shown in the foregoing embodiment, an embodiment of this application further provides a switch status detection method using the switch status detection circuit shown in the foregoing embodiment. For example, FIG. 10 is a schematic flowchart of a switch status detection method according to an embodiment of this application. The switch status detection method may include the following steps.

S1001. Separately detect a voltage at a first sampling point and a voltage at a second sampling point.

S 1002. Determine a status of a first switch based on the voltage at the first sampling point, and determine a status of a second switch based on the voltage at the second sampling point.

The status includes a closed state, an open state, or a contact failure.

It can be understood that, in this embodiment of this application, after the status of the first switch is determined based on the voltage at the first sampling point and the status of the second switch is determined based on the voltage at the second sampling point, whether the first switch or the second switch is adhered may be further determined based on the status of the first switch and the status of the second switch. If it is determined that a switch of the first switch and the second switch is adhered, an alarm mode is triggered, to report a switch failure.

Optionally, the switch status detection method may further include:

when the voltage at the first sampling point is higher than a clamping voltage of a clamping circuit, performing clamping processing on the voltage at the first sampling point, so that a processed voltage at the first sampling point is equal to the clamping voltage; and/or
when the voltage at the second sampling point is higher than the clamping voltage of the clamping circuit, performing clamping processing on the voltage at the second sampling point, so that a processed voltage at the second sampling point is equal to the clamping voltage.

Optionally, the determining a status of a first switch based on the voltage at the first sampling point may include: if the voltage at the first sampling point is 0 V, determining, by a control chip, that the status of the first switch is an open state; if the voltage at the first sampling point is a first preset voltage, determining, by a control chip, that the status of the first switch is a closed state; if the voltage at the first sampling point is the clamping voltage, a status of a third switch is a closed state, and failure information used to indicate that a power supply module is not properly charged is received, determining that the status of the first switch is an open state; or if the voltage at the first sampling point is the clamping voltage, a status of a third switch is a closed state, and no failure information used to indicate that a power supply module is not properly charged is received, determining that the status of the first switch is a closed state.

Optionally, the determining a status of a second switch based on the voltage at the second sampling point may include:
if the voltage at the second sampling point is 0 V, determining that the status of the second switch is a closed state; or if the voltage at the second sampling point is a second preset voltage, determining that the status of the second switch is an open state.

With the switch status detection method shown in this embodiment of this application, during detection on a status of a switch, complexity of a detection circuit is reduced, and accuracy of a detection result is also improved. An implementation principle and a beneficial effect of the switch status detection method are similar to those of the switch status detection circuit. Details are not described herein again.

An embodiment of this application further provides a switch status detection apparatus. The switch status detection apparatus may include a power supply module and the switch status detection circuit in the foregoing embodiment. A first end of the switch status detection circuit is connected to a charging device. A second end of the switch status detection circuit is connected to the power supply module. The charging device charges the power supply module by using the switch status detection circuit.

With the switch status detection apparatus provided in this embodiment of this application, during detection on a status of a switch, complexity of a detection circuit is reduced, and accuracy of a detection result is also improved. An implementation principle and a beneficial effect of the switch status detection apparatus are similar to those of the switch status detection circuit. Details are not described herein again.

An embodiment of this application further provides an electric device. The electric device may include the switch status detection apparatus in the foregoing embodiment. During detection on a status of a switch, complexity of a detection circuit is reduced, and accuracy of a detection result is also improved. An implementation principle and a beneficial effect of the electric device are similar to those of the switch status detection circuit. Details are not described herein again.

In the several embodiments provided in this application, it should be understood that the disclosed apparatus and method may be implemented in another manner. For example, the described apparatus embodiment is merely an example. For example, division into the units is merely logical functional division and may be other division in an actual implementation. For example, a plurality of units or components may be combined or integrated into another system, or some features may be ignored or not performed. In addition, the displayed or discussed mutual couplings or direct couplings or communication connections may be implemented through some interfaces. Indirect couplings or communication connections between the apparatuses or units may be implemented in electrical, mechanical, or other forms.

The units described as separate parts may or may not be physically separate, and parts displayed as units may or may not be physical units, may be located in one location, or may be distributed on a plurality of network units. Some or all of the units may be selected depending on actual requirements to achieve the objectives of the solutions in the embodiments.

In addition, functional units in embodiments of this application may be integrated into one processing unit, or each of the units may exist alone physically, or two or more units are integrated into one unit. The integrated unit may be implemented in a form of hardware, or may be implemented in a form of hardware plus a software functional unit.

**Claims**

1. A switch status detection circuit, comprising a first switch, a second switch, a first voltage divider circuit, a second voltage divider circuit, a third voltage divider circuit, and a control chip, wherein

    a first end of the first switch is connected to a power source (Vcc) through the first voltage divider circuit, the first end of the first switch is connected to a power supply module, a second end of the first switch is separately connected to a charging device and a first end of the second voltage divider circuit, a second end of the second voltage divider circuit is grounded, a first end of the second switch is connected to the power source (Vcc) through a first end of the third voltage divider circuit, the first end of the second switch is connected to the charging device, a second end of the third voltage divider circuit is grounded and is connected to the power supply module, and both a first sampling point of the second voltage divider circuit and a second sampling point of the third voltage divider circuit are connected to the control chip;
    the control chip is configured to detect a voltage at the first sampling point, and determine a status of the first switch based on the voltage at the first sampling point, wherein the status comprises a closed state, an open state, or a contact failure; and
    the control chip is further configured to detect a voltage at the second sampling point, and determine a status of the second switch based on the voltage at the second sampling point.

2. The circuit according to claim 1, wherein the circuit further comprises a clamping circuit, and both the first sampling point of the second voltage divider circuit and the second sampling point of the third voltage divider circuit are connected to the control chip through the clamping circuit; and

    the clamping circuit is configured to: when the voltage at the first sampling point is higher than a clamping voltage of the clamping circuit, perform clamping processing on the voltage at the first sampling point, so that a processed voltage at the first sampling point is equal to the clamping voltage; and/or
    the clamping circuit is configured to: when the voltage at the second sampling point is higher than the clamping voltage of the clamping circuit, perform clamping processing on the voltage at the second sampling point, so that a processed voltage at the second sampling point is equal to the clamping voltage.

3. The circuit according to claim 2, wherein the first end of the first switch is connected to the power supply module through a third switch; and
    the control chip is specifically configured to: if the voltage at the first sampling point is 0 V, determine that the status of the first switch is an open state; if the voltage at the first sampling point is a first preset voltage, determine that the status of the first switch is a closed state; if the voltage at the first sampling point is the clamping voltage, a status of the third switch is a closed state, and failure information used to indicate that the power supply module is not properly charged is received, determine that the status of the first switch is an open state; or if the voltage at the first sampling point is the clamping voltage, a status of the third switch is a closed state, and no failure information used to indicate that the power supply module is not properly charged is received, determine that the status of the first switch is a closed state.

4. The circuit according to any one of claims 1 to 3, wherein
    the control chip is specifically configured to: if the voltage at the second sampling point is 0 V, determine that the status of the second switch is a closed state; or if the voltage at the second sampling point is a second preset voltage, determine that the status of the second switch is an open state.

5. The circuit according to any one of claims 1 to 4, wherein
the first voltage divider circuit comprises a first resistor.

6. The circuit according to any one of claims 1 to 5, wherein the second voltage divider circuit comprises a second resistor and a third resistor; and
a first end of the second resistor is separately connected to the charging device and the second end of the first switch, a second end of the second resistor is connected to a first end of the third resistor, a second end of the third resistor is grounded, and the first sampling point is located on a connection line between the second end of the second resistor and the first end of the third resistor.

7. The circuit according to any one of claims 1 to 6, wherein the third voltage divider circuit comprises a fourth resistor and a fifth resistor; and
a first end of the fourth resistor is connected to the power source, the fifth resistor is connected in parallel to the second switch, a first end obtained by connecting the fifth resistor and the second switch in parallel is separately connected to the charging device and a second end of the fourth resistor, a second end obtained by connecting the fifth resistor and the second switch in parallel is grounded and is connected to the power supply module, and the second sampling point is located on a connection line between the second end of the fourth resistor and the first end obtained by connecting the fifth resistor and the second switch in parallel.

8. A switch status detection method, using the switch status detection circuit according to any one of claims 1 to 7, wherein the method comprises:

    separately detecting (S1001) a voltage at a first sampling point and a voltage at a second sampling point; and
    determining (S1002) a status of a first switch based on the voltage at the first sampling point, and determining a status of a second switch based on the voltage at the second sampling point, wherein the status comprises a closed state, an open state, or a contact failure.

9. The method according to claim 8, wherein the method further comprises:

    when the voltage at the first sampling point is higher than a clamping voltage of a clamping circuit, performing clamping processing on the voltage at the first sampling point, so that a processed voltage at the first sampling point is equal to the clamping voltage; and/or
    when the voltage at the second sampling point is higher than the clamping voltage of the clamping circuit, performing clamping processing on the voltage at the second sampling point, so that a processed voltage at the second sampling point is equal to the clamping voltage.

10. The method according to claim 8 or 9, wherein the determining (S1002) a status of a first switch based on the voltage at the first sampling point comprises:

    if the voltage at the first sampling point is 0 V, determining, by a control chip, that the status of the first switch is an open state;
    if the voltage at the first sampling point is a first preset voltage, determining, by a control chip, that the status of the first switch is a closed state;
    if the voltage at the first sampling point is the clamping voltage, a status of a third switch is a closed state, and failure information used to indicate that a power supply module is not properly charged is received, determining that the status of the first switch is an open state; or
    if the voltage at the first sampling point is the clamping voltage, a status of a third switch is a closed state, and no failure information used to indicate that a power supply module is not properly charged is received, determining that the status of the first switch is a closed state.

11. The method according to any one of claims 8 to 10, wherein the determining (S1002) a status of a second switch based on the voltage at the second sampling point comprises:

    if the voltage at the second sampling point is 0 V, determining that the status of the second switch is a closed state; or
    if the voltage at the second sampling point is a second preset voltage, determining that the status of the second switch is an open state.

**12.** A switch status detection apparatus, comprising a power supply module and the switch status detection circuit according to any one of claims 1 to 7, wherein a first end of the switch status detection circuit is connected to a charging device, and a second end of the switch status detection circuit is connected to the power supply module; and the charging device charges the power supply module by using the switch status detection circuit.

**13.** An electric device, comprising the switch status detection apparatus according to claim 12.

**Patentansprüche**

**1.** Schaltung zur Schalterstatuserkennung, umfassend einen ersten Schalter, einen zweiten Schalter, eine erste Spannungsteilerschaltung, eine zweite Spannungsteilerschaltung, eine dritte Spannungsteilerschaltung und einen Steuerchip umfasst, wobei

ein erstes Ende des ersten Schalters über die erste Spannungsteilerschaltung mit einer Stromquelle (Vcc) verbunden ist, das erste Ende des ersten Schalters mit einem Stromversorgungsmodul verbunden ist, ein zweites Ende des ersten Schalters separat mit einer Ladevorrichtung und einem ersten Ende der zweiten Spannungsteilerschaltung verbunden ist, ein zweites Ende der zweiten Spannungsteilerschaltung geerdet ist, ein erstes Ende des zweiten Schalters über ein erstes Ende der dritten Spannungsteilerschaltung mit der Stromquelle (Vcc) verbunden ist, das erste Ende des zweiten Schalters mit der Ladevorrichtung verbunden ist, ein zweites Ende der dritten Spannungsteilerschaltung geerdet ist und mit dem Stromversorgungsmodul verbunden ist, und sowohl ein erster Abtastpunkt der zweiten Spannungsteilerschaltung als auch ein zweiter Abtastpunkt der dritten Spannungsteilerschaltung mit dem Steuerchip verbunden sind;
der Steuerchip dazu konfiguriert ist, eine Spannung an dem ersten Abtastpunkt zu erkennen und einen Status des ersten Schalters basierend auf der Spannung an dem ersten Abtastpunkt zu bestimmen, wobei der Status einen geschlossenen Zustand, einen offenen Zustand oder einen Kontaktfehler umfasst; und
der Steuerchip ferner dazu konfiguriert ist, eine Spannung an dem zweiten Abtastpunkt zu erkennen und einen Status des zweiten Schalters basierend auf der Spannung an dem zweiten Abtastpunkt zu bestimmen.

**2.** Schaltung nach Anspruch 1, wobei die Schaltung ferner eine Klemmschaltung umfasst und sowohl der erste Abtastpunkt der zweiten Spannungsteilerschaltung als auch der zweite Abtastpunkt der dritten Spannungsteilerschaltung über die Klemmschaltung mit dem Steuerchip verbunden sind; und

die Klemmschaltung dazu konfiguriert ist: wenn die Spannung an dem ersten Abtastpunkt höher als eine Klemmspannung der Klemmschaltung ist, eine Klemmverarbeitung an der Spannung an dem ersten Abtastpunkt durchzuführen, so dass eine verarbeitete Spannung an dem ersten Abtastpunkt gleich der Klemmspannung ist; und/oder
die Klemmschaltung dazu konfiguriert ist: wenn die Spannung an dem zweiten Abtastpunkt höher als die Klemmspannung der Klemmschaltung ist, eine Klemmverarbeitung an der Spannung an dem zweiten Abtastpunkt durchzuführen, so dass eine verarbeitete Spannung an dem zweiten Abtastpunkt gleich der Klemmspannung ist.

**3.** Schaltung nach Anspruch 2, wobei das erste Ende des ersten Schalters über einen dritten Schalter mit dem Stromversorgungsmodul verbunden ist; und
der Steuerchip speziell dazu konfiguriert ist: wenn die Spannung an dem ersten Abtastpunkt 0 V beträgt, zu bestimmen, dass der Status des ersten Schalters ein offener Zustand ist; wenn die Spannung an dem ersten Abtastpunkt eine erste voreingestellte Spannung ist, zu bestimmen, dass der Status des ersten Schalters ein geschlossener Zustand ist; wenn die Spannung an dem ersten Abtastpunkt die Klemmspannung ist, ein Status des dritten Schalters ein geschlossener Zustand ist und Fehlerinformationen, die verwendet werden, um darauf hinweisen, dass das Stromversorgungsmodul nicht richtig geladen ist, empfangen werden, zu bestimmen, dass der Status des ersten Schalters ein geöffneter Zustand ist; oder wenn die Spannung an dem ersten Abtastpunkt die Klemmspannung ist, ein Status des dritten Schalters ein geschlossener Zustand ist und keine Fehlerinformationen, die verwendet werden, um darauf hinweisen, dass das Stromversorgungsmodul nicht richtig geladen ist, empfangen werden, zu bestimmen, dass der Status des ersten Schalters ein geschlossener Zustand ist.

**4.** Schaltung nach einem der Ansprüche 1 bis 3, wobei
der Steuerchip speziell dazu konfiguriert ist: wenn die Spannung an dem zweiten Abtastpunkt 0 V beträgt, zu bestimmen, dass der Status des zweiten Schalters ein geschlossener Zustand ist; oder wenn die Spannung an dem zweiten Abtastpunkt eine zweite voreingestellte Spannung ist, zu bestimmen, dass der Status des zweiten Schalters ein offener Zustand ist.

5. Schaltung nach einem der Ansprüche 1 bis 4, wobei
die erste Spannungsteilerschaltung einen ersten Widerstand umfasst.

6. Schaltung nach einem der Ansprüche 1 bis 5, wobei die zweite Spannungsteilerschaltung einen zweiten Widerstand und einen dritten Widerstand umfasst, und
ein erstes Ende des zweiten Widerstands separat mit der Ladevorrichtung und dem zweiten Ende des ersten Schalters verbunden ist, ein zweites Ende des zweiten Widerstands mit einem ersten Ende des dritten Widerstands verbunden ist, ein zweites Ende des dritten Widerstands geerdet ist und sich der erste Abtastpunkt auf einer Verbindungsleitung zwischen dem zweiten Ende des zweiten Widerstands und dem ersten Ende des dritten Widerstands befindet.

7. Schaltung nach einem der Ansprüche 1 bis 6, wobei die dritte Spannungsteilerschaltung einen vierten Widerstand und einen fünften Widerstand umfasst; und
ein erstes Ende des vierten Widerstands mit der Stromquelle verbunden ist, der fünfte Widerstand parallel zu dem zweiten Schalter geschaltet ist, ein erstes Ende, das durch Parallelschalten des fünften Widerstands und des zweiten Schalters erlangt wird, separat mit dem Ladevorrichtung und einem zweiten Ende des vierten Widerstands verbunden ist, ein zweites Ende, das durch Parallelschalten des fünften Widerstands und des zweiten Schalters erlangt wird, geerdet ist und mit dem Stromversorgungsmodul verbunden ist, und sich der zweite Abtastpunkt auf einer Verbindungsleitung zwischen dem zweiten Ende des vierten Widerstands und dem ersten Ende, das durch Parallelschalten des fünften Widerstands und des zweiten Schalters erlangt wird, befindet.

8. Verfahren zur Schalterstatuserkennung unter Verwendung der Schaltung zur Schalterstatuserkennung nach einem der Ansprüche 1 bis 7, wobei das Verfahren Folgendes umfasst:

separates Erkennen (S1001) einer Spannung an einem ersten Abtastpunkt und einer Spannung an einem zweiten Abtastpunkt; und
Bestimmen (S1002) eines Status eines ersten Schalters basierend auf der Spannung an dem ersten Abtastpunkt, und Bestimmen eines Status eines zweiten Schalters basierend auf der Spannung an dem zweiten Abtastpunkt, wobei der Status einen geschlossenen Zustand, einen offenen Zustand oder einen Kontaktfehler umfasst.

9. Verfahren nach Anspruch 8, wobei das Verfahren ferner Folgendes umfasst:

wenn die Spannung an dem ersten Abtastpunkt höher als eine Klemmspannung einer Klemmschaltung ist, Durchführen einer Klemmverarbeitung an der Spannung an dem ersten Abtastpunkt, so dass eine verarbeitete Spannung an dem ersten Abtastpunkt gleich der Klemmspannung ist; und/oder
wenn die Spannung an dem zweiten Abtastpunkt höher als die Klemmspannung der Klemmschaltung ist, Durchführen einer Klemmverarbeitung an der Spannung an dem zweiten Abtastpunkt, so dass eine verarbeitete Spannung an dem zweiten Abtastpunkt gleich der Klemmspannung ist.

10. Verfahren nach Anspruch 8 oder 9, wobei das Bestimmen (S1002) eines Status eines ersten Schalters basierend auf der Spannung an dem ersten Abtastpunkt Folgendes umfasst:

wenn die Spannung an dem ersten Abtastpunkt 0 V beträgt, Bestimmen durch einen Steuerchip, dass der Status des ersten Schalters ein offener Zustand ist;
wenn die Spannung an dem ersten Abtastpunkt eine erste voreingestellte Spannung ist, Bestimmen durch einen Steuerchip, dass der Status des ersten Schalters ein geschlossener Zustand ist;
wenn die Spannung an dem ersten Abtastpunkt die Klemmspannung ist, ein Status eines dritten Schalters ein geschlossener Zustand ist und Fehlerinformationen, die verwendet werden, um darauf hinzuweisen, dass ein Stromversorgungsmodul nicht richtig geladen ist, empfangen werden, Bestimmen, dass der Status des ersten Schalters ein offener Zustand ist; oder
wenn die Spannung an dem ersten Abtastpunkt die Klemmspannung ist, ein Status eines dritten Schalters ein geschlossener Zustand ist und keine Fehlerinformationen, die verwendet werden, um darauf hinzuweisen, dass ein Stromversorgungsmodul nicht richtig geladen ist, empfangen werden, Bestimmen, dass der Status des ersten Schalters ein geschlossener Zustand ist.

**11.** Verfahren nach einem der Ansprüche 8 bis 10, wobei das Bestimmen (S1002) eines Status eines zweiten Schalters basierend auf der Spannung an dem zweiten Abtastpunkt Folgendes umfasst:

wenn die Spannung an dem zweiten Abtastpunkt 0 V beträgt, Bestimmen, dass der Status des zweiten Schalters ein geschlossener Zustand ist; oder
wenn die Spannung an dem zweiten Abtastpunkt eine zweite voreingestellte Spannung ist, Bestimmen, dass der Status des zweiten Schalters ein offener Zustand ist.

**12.** Vorrichtung zur Schalterstatuserkennung, umfassend ein Stromversorgungsmodul und die Schaltung zur Schalterstatuserkennung nach einem der Ansprüche 1 bis 7, wobei ein erstes Ende der Schaltung zur Schalterstatuserkennung mit einer Ladevorrichtung verbunden ist und ein zweites Ende der Schaltung zur Schalterstatuserkennung mit dem Stromversorgungsmodul verbunden ist; und
die Ladevorrichtung das Stromversorgungsmodul unter Verwendung der Schaltung zur Schalterstatuserkennung lädt.

**13.** Elektrische Vorrichtung, umfassend die Vorrichtung zur Schalterstatuserkennung nach Anspruch 12.

**Revendications**

**1.** Circuit de détection d'état de commutateur, comprenant un premier commutateur, un deuxième commutateur, un premier circuit diviseur de tension, un deuxième circuit diviseur de tension, un troisième circuit diviseur de tension et une puce de commande, dans lequel

une première extrémité du premier commutateur est connectée à une source d'alimentation (Vcc) par l'intermédiaire du premier circuit diviseur de tension, la première extrémité du premier commutateur est connectée à un module d'alimentation, une seconde extrémité du premier commutateur est connectée séparément à un dispositif de charge et à une première extrémité du second circuit diviseur de tension, une seconde extrémité du second circuit diviseur de tension est mise à la terre, une première extrémité du deuxième commutateur est connectée à la source d'alimentation (Vcc) par l'intermédiaire d'une première extrémité du troisième circuit diviseur de tension, la première extrémité du deuxième commutateur est connectée au dispositif de charge, une seconde extrémité du troisième circuit diviseur de tension est mise à la terre et est connectée au module d'alimentation, et à la fois un premier point d'échantillonnage du deuxième circuit diviseur de tension et un second point d'échantillonnage du troisième circuit diviseur de tension sont connectés à la puce de commande ;
la puce de commande est configurée pour détecter une tension au niveau du premier point d'échantillonnage et déterminer un état du premier commutateur sur la base de la tension au niveau du premier point d'échantillonnage, dans lequel l'état comprend un état fermé, un état ouvert ou une défaillance de contact ; et
la puce de commande est également configurée pour détecter une tension au niveau du second point d'échantillonnage et déterminer un état du deuxième commutateur sur la base de la tension au niveau du second point d'échantillonnage.

**2.** Circuit selon la revendication 1, dans lequel le circuit comprend également un circuit de serrage, et à la fois le premier point d'échantillonnage du deuxième circuit diviseur de tension et le second point d'échantillonnage du troisième circuit diviseur de tension sont connectés à la puce de commande par l'intermédiaire du circuit de serrage ; et

le circuit de serrage est configuré pour : lorsque la tension au niveau du premier point d'échantillonnage est supérieure à une tension de serrage du circuit de serrage, réaliser un traitement de serrage sur la tension au niveau du premier point d'échantillonnage, de sorte qu'une tension traitée au niveau du premier point d'échantillonnage soit égale à la tension de serrage ; et/ou
le circuit de serrage est configuré pour : lorsque la tension au niveau du second point d'échantillonnage est supérieure à une tension de serrage du circuit de serrage, réaliser un traitement de serrage sur la tension au niveau du second point d'échantillonnage, de sorte qu'une tension traitée au niveau du second point d'échantillonnage soit égale à la tension de serrage.

**3.** Circuit selon la revendication 2, dans lequel la première extrémité du premier commutateur est connectée au module d'alimentation par l'intermédiaire d'un troisième commutateur ; et
la puce de commande est spécifiquement configurée pour : si la tension au niveau du premier point d'échantillonnage est de 0 V, déterminer le fait que l'état du premier commutateur est un état ouvert ; si la tension au niveau du premier point d'échantillonnage est une première tension prédéfinie, déterminer le fait que l'état du premier commutateur est un état fermé ; si la tension au niveau du premier point d'échantillonnage est la tension de serrage, un état du troisième commutateur est un état fermé et des informations de défaillance utilisées pour indiquer que le module d'alimentation n'est pas correctement chargé sont reçues, déterminer le fait que l'état du premier commutateur est un état ouvert ; ou si la tension au niveau du premier point d'échantillonnage est la tension de serrage, un état du troisième commutateur est un état fermé et aucune information de défaillance utilisée pour indiquer que le module d'alimentation n'est pas correctement chargé n'est reçue, déterminer le fait que l'état du premier commutateur est un état fermé.

4. Procédé selon l'une quelconque des revendications 1 à 3, dans lequel
la puce de commande est spécifiquement configurée pour : si la tension au niveau du second point d'échantillonnage est de 0 V, déterminer le fait que l'état du deuxième commutateur est un état fermé ; ou si la tension au niveau du second point d'échantillonnage est une seconde tension prédéfinie, déterminer le fait que l'état du deuxième commutateur est un état ouvert.

5. Circuit selon l'une quelconque des revendications 1 à 4, dans lequel
le premier circuit diviseur de tension comprend une première résistance.

6. Circuit selon l'une quelconque des revendications 1 à 5, dans lequel le deuxième circuit diviseur de tension comprend une deuxième résistance et une troisième résistance, et
une première extrémité de la deuxième résistance est connectée séparément au dispositif de charge et à la seconde extrémité du premier commutateur, une seconde extrémité de la deuxième résistance est connectée à une première extrémité de la troisième résistance, une seconde extrémité de la troisième résistance est mise à la terre, et le premier point d'échantillonnage est situé sur une ligne de connexion entre la seconde extrémité de la deuxième résistance et la première extrémité de la troisième résistance.

7. Circuit selon l'une quelconque des revendications 1 à 6, dans lequel le troisième circuit diviseur de tension comprend une quatrième et une cinquième résistances ; et
une première extrémité de la quatrième résistance est connectée à la source d'alimentation, la cinquième résistance est connectée en parallèle au deuxième commutateur, une première extrémité obtenue en connectant la cinquième résistance et le deuxième commutateur en parallèle est connectée séparément au dispositif de charge et une seconde extrémité de la quatrième résistance, une seconde extrémité obtenue en connectant la cinquième résistance et le deuxième commutateur en parallèle est mise à la terre et est connectée au module d'alimentation, et le second point d'échantillonnage est situé sur une ligne de connexion entre la seconde extrémité de la quatrième résistance et la première extrémité obtenue en connectant la cinquième résistance et le deuxième commutateur en parallèle.

8. Procédé de détection d'état de commutateur, utilisant le circuit de détection d'état de commutateur selon l'une quelconque des revendications 1 à 7, dans lequel le procédé comprend :

la détection de manière séparée (S1001) d'une tension au niveau d'un premier point d'échantillonnage et une tension au niveau d'un second point d'échantillonnage ; et
la détermination (S1002) d'un état d'un premier commutateur sur la base de la tension au niveau du premier point d'échantillonnage, et la détermination d'un état d'un deuxième commutateur sur la base de la tension au niveau du second point d'échantillonnage, dans lequel l'état comprend un état fermé, un état ouvert ou une défaillance de contact.

9. Procédé selon la revendication 8, dans lequel le procédé comprend également :

lorsque la tension au niveau du premier point d'échantillonnage est supérieure à une tension de serrage du circuit de serrage, la réalisation d'un traitement de serrage sur la tension au niveau du premier point d'échantillonnage, de sorte qu'une tension traitée au niveau du premier point d'échantillonnage soit égale à la tension de serrage ; et/ou
lorsque la tension au niveau du second point d'échantillonnage est supérieure à une tension de serrage du circuit de serrage, la réalisation d'un traitement de serrage sur la tension au niveau du second point d'échantillonnage, de sorte qu'une tension traitée au niveau du second point d'échantillonnage soit égale à la tension de serrage.

10. Procédé selon la revendication 8 ou 9, dans lequel la détermination (S1002) d'un état d'un premier commutateur sur la base de la tension au niveau du premier point d'échantillonnage comprend :

si la tension au niveau du premier point d'échantillonnage est de 0 V, la détermination, par une puce de commande, du fait que l'état du premier commutateur est un état ouvert ;

si la tension au niveau du premier point d'échantillonnage est une première tension prédéfinie, la détermination, par une puce de commande, du fait que l'état du premier commutateur est un état fermé ;

si la tension au niveau du premier point d'échantillonnage est la tension de serrage, un état d'un troisième commutateur est un état fermé et les informations de défaillance utilisées pour indiquer qu'un module d'alimentation n'est pas correctement chargé sont reçues, la détermination du fait que l'état du premier commutateur est un état ouvert ; ou

si la tension au niveau du premier point d'échantillonnage est la tension de serrage, un état d'un troisième commutateur est un état fermé et aucune information de défaillance n'est utilisée pour indiquer qu'un module d'alimentation n'est pas correctement chargé sont reçues, la détermination du fait que l'état du premier commutateur est un état fermé.

11. Procédé selon l'une quelconque des revendications 8 à 10, dans lequel la détermination (S1002) d'un état d'un deuxième commutateur sur la base de la tension au niveau du second point d'échantillonnage comprend :

si la tension au niveau du second point d'échantillonnage est de 0 V, la détermination du fait que l'état du deuxième commutateur est un état fermé ; ou

si la tension au niveau du second point d'échantillonnage est une seconde tension prédéfinie, la détermination du fait que l'état du deuxième commutateur est un état ouvert.

12. Appareil de détection d'état de commutateur, comprenant un module d'alimentation et le circuit de détection d'état de commutateur selon l'une quelconque des revendications 1 à 7, dans lequel une première extrémité du circuit de détection d'état de commutateur est connectée à un dispositif de charge, et une seconde extrémité du circuit de détection d'état de commutateur est connectée au module d'alimentation ; et

le dispositif de charge utilise le circuit de détection d'état du commutateur pour charger le module d'alimentation.

13. Dispositif électrique, comprenant l'appareil de détection d'état de commutateur selon la revendication 12.

FIG. 1

FIG. 2

EP 4 145 153 B1

Switch status detection circuit

Vcc

First voltage divider circuit

First switch

Charging device

Second voltage divider circuit

Vcc

Third voltage divider circuit

Control chip

Charging module

Second switch

FIG. 3

FIG. 4

FIG. 5

FIG. 6

FIG. 7

FIG. 8

FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190064280 A1
- US 20200049768 A1

- CN 102830351 A